# EUROPEAN PATENT SPECIFICATION

(11) **EP 4 600 463 B1**
(45) Date of publication and mention of the grant of the patent: **26.08.2026**
(21) Application number: 24156592.8
(22) Date of filing: 08.02.2024
(51) Int. Cl.: E21C 37/16, E21C 41/16, F42D 3/04

(54) **APPARATUS AND METHOD DESIGNING CHARGING AND BLASTING FOR STOPE EXCAVATION**
VORRICHTUNG UND VERFAHREN ZUM ENTWURF VON LADUNG UND SPRENGEN FÜR STOPPAUSHUB
APPAREIL ET PROCÉDÉ DE CONCEPTION DE CHARGE ET DE SAUTAGE POUR EXCAVATION DE BUTÉE

(43) Date of publication of application: 13.08.2025
(73) Proprietor: Sandvik Mining and Construction Oy, 33330 Tampere (FI)
(72) Inventor: Muona, Jouko, 33311 Tampere (FI); Hyvönen, Petteri, 33311 Tampere (FI); Kokkoniemi, Tuomas, 33311 Tampere (FI)
(74) Representative: Sandvik

(56) References cited:
- EP-A1- 3 690 186
- CN-A- 106 761 757
- CN-B- 106 761 745
- SE-A1- 2 130 072
- US-A1- 2023 203 946
- ONEDERRA I ET AL: "Design methodology for underground ring blasting", MINING TECHNOLOGY, vol. 116, no. 4, 1 December 2007 (2007-12-01), pages 180 - 195, XP093172132, ISSN: 1474-9009, DOI: 10.1179/174328607X282244
- RODRIGUEZ ALVEAL FELIPE ET AL: "Blasting design and drawbell implementation at the Chuquicamata Underground mine", MASSMIN 2020: PROCEEDINGS OF THE EIGHTH INTERNATIONAL CONFERENCE & EXHIBITION ON MASS MINING, 1 January 2020 (2020-01-01), pages 897 - 909, XP093172188, DOI: 10.36487/ACG_repo/2063_64
- HAWKINS ELLIE: "Optimisation of blasting practices in caving operations Optimisation of blasting practices in caving operations", 30 July 2021 (2021-07-30), XP093172632, Retrieved from the Internet <URL:https://ro.uow.edu.au/cgi/viewcontent.cgi?article=2231&context=theses1>

## Description

### Background of the invention

The invention relates to a stope excavation in an underground mine. More specifically the invention relates to an apparatus comprising at least one data processing device for assisting designing charging and blasting of drill holes of several vertical stope rings for the stope excavation.

The invention further relates to a method for assisting designing charging and blasting of drill holes of vertical stope rings for a stope excavation.

The field of the invention is defined more specifically in the preambles of the independent claims.

Stope excavation is an underground mining technique wherein desired ore is extracted from an underground mine. In general, the stope excavation typically comprises several successive vertical or slightly inclined stope rings of rock material which are each blasted separately in partial blasts towards a premade free space below the stopes. After the first stope ring is entirely blasted and emptied, there is a free space for the following stope ring blasts not only below but also in lateral direction. Thus, the blasting of the first stope ring is a critical phase since there is only a limited free space below the first stope ring. Designing charging and blasting plans for the stope excavation is a demanding and time consuming task, see for example "Design methodology for underground ring blasting", MINING TECHNOLOGY, vol. 116, no. 4, 1 December 2007 , pages 180-195 (DOI: 10.1179/174328607X282244) and EP3690186. Further, it has been noted that there may exist unwanted variations in blasting results because of defects in the charging and blasting plans.

### Brief description of the invention

An object of the invention is to provide a novel and improved apparatus and method for assisting designing charging and blasting of drill holes of vertical stope rings.

The apparatus according to the invention is characterized by the features of the independent apparatus claim.

The method according to the invention is characterized by the features of the independent method claim.

An idea of the disclosed solution is that a designer is provided with an apparatus for assisting designing charging and blasting of drill holes of several vertical stope rings utilized in a stope excavation in an underground mine. Each stope ring comprises two or more parallel or near parallel drill hole fans provided with several downwards or upwards directed drill holes. The apparatus comprises one or more data processing devices and is provided with data on realized drill holes drilled for a stope and is provided also with data on an initial free space located below or at least partly below the stope. The apparatus assists in dividing an initial first stope ring into several blast sections which are configured to be blasted in several partial blasts towards an available free space including at least the initial free space. The apparatus estimates volume of rock material of selected blast sections in solid non-blasted state and also in blasted expanded state. The apparatus further estimates volume of the available free space at the first stope ring. Furthermore, the apparatus compares the volume of the selected blast section in the blasted expanded state to the volume of the available free space and indicates, based on the comparison, when the selected blast section fits in the blasted expanded state into the available free space.

In other words, the apparatus can provide valuable information for designing the charging and blasting order of different blast sections of the first stope ring. When this data is implemented, it is possible to avoid problems in the blasting process. A proper blasting requires that there is sufficient volume for the rock material being blasted and expanded.

Thereby, an advantage of the disclosed solution is that a possible stope blocking problem can be effectively avoided. Then complicated and dangerous corrective drilling and blasting measures are not needed and the stope blasting process can proceed smoothly and effectively.

In the stope excavation the drill holes are long holes which serve as blast holes and which extend from an upper premade horizontal space, such as an upper drift, towards a lower premade horizontal space, such as a lower drift. Thus, the upper drift serves as a first passage for executing the drilling and charging, whereas the lower drift serves as a second passage for emptying the free space by means of a wheel loader type mining vehicle, for example. Most of the drill holes are arranged in a fan like pattern whereby only some of them are open to the lower drift.

However, it is also possible to drill the drill holes from the lower drift towards the surface i.e., the drilling is done from the bottom up. Charging of the drill holes can be done from the upper drift. Also in this alternative case, the blasted rock is designed to fall to the lower drift wherefrom the broken rock material is emptied.

A general advantage of the disclosed stope excavation is that it is an effective mining technique wherein rock material is excavated in partial blast and wherein gravity and throw of the blast is utilized for moving the blasted broken rock material towards the lower drift below the blasted stope.

According to an embodiment, the data processing device of the apparatus is provided with at least one computer program product and execution of the computer program product is configured to execute the disclosed steps for assisting the charging and blasting design work of a designer.

According to an embodiment, each stope ring comprises two or more parallel or substantially parallel drill hole fans provided with several drill holes.

According to an embodiment, the apparatus is provided with data on magnitude of expansion of the rock material of the stope. The apparatus may be provided with data on rock type and quality of an ore body and the apparatus may consider the rock data when estimating the expansion of the blasted rock material.

Alternatively, the apparatus may be provided with a swell factor of the blasted rock whereby the apparatus may calculate the volume of the blasted rock material when the volume in the solid state is known. Typically the blasted rock material contains 25 - 30 percent voids and therefore needs more space compared to solid non-blasted rock.

The available free space expands gradually when the blast sections are blasted, and when the blast broken rock material is emptied through the initial free space below the stope. The initial free space may thereby serve as a space to receive the blasted rock material and also as a hauling passage below the stope. The blasting process comprises emptying the free space between the blasting sequences. Each following blast section can have larger volume than the previous blast section since an enlarged available total free space is provided after each partial blast.

Thus, the available free space is a currently available free space which expands when the successive partial blasts of the selected blast sections proceed further.

The vertically downwards directed drill holes of the vertical stope form a fan-shaped pattern and are drilled with implementing downwards directed fan drilling method. The drill holes are drilled to a floor of the upper drift by means of a long-hole rock drilling rig. Then drill hole openings are located on the floor of the upper drift. The drill holes are blast holes which are charged with blasting material inserted to the drill holes from the upper drift by means of a charging rig.

Alternatively, the vertically upwards directed drill holes of the vertical stope are drilled to a roof of the lower drift by means of a long-hole rock drilling rig. The drill holes are charged with blasting material from the lower drift. In this alternative an upper drift is not necessarily needed since the operation utilizes the lower drift.

According to an embodiment, the apparatus is configured to assist designing a slot for the first stope ring. And further, the apparatus is configured to assist in dividing the slot into at least two partial slots one on top of the other. A first partial slot is located closest to the initial free space and is provided with a prior blasting order than a second partial slot vertically above the first partial slot. The apparatus is configured to estimate volume of rock material in the blasted expanded state of the first partial slot and compares the estimated volume to the volume of the initial free space.

In other words, the apparatus calculates the blasted volume of the first blast section of the initial first stope ring i.e., the first partial slot, wherefrom the entire blasting process of the stope starts.

In the stope excavation length of the slot is great whereby the whole length of the slot cannot be blasted in one go, as the expanding rock volume does not fit into free volume of the existing drift below the stope.

The apparatus can help the designer to set the lengths of the partial slots so that magnitudes of the volumes are suitable. Thus, charging of the slot is executed in accordance with the designed partial slots. And of course blasting order of the partial slots is also determined.

An advantage of the solution is that assistance is provided for a designer to divide the slot into two or more blast sections i.e., into the partial slots, so that the blasted rock material of the first blast fits reliably into the initial free space. This way problems in blasting of the slot may be avoided and smooth start for the blasting of the first stope ring is ensured. Blasting efficiency and safety may be improved when stope slot blocking can be diminished.

Blasting of the slot is typically the most critical phase in the stope blasting process. Assistance for this critical phase is provided by means of the apparatus.

After the blast of the first partial slot, the initial free space is emptied, and the second partial slot is blasted thereafter. When the entire slot is blasted, then other blast sections widening the slot can be blasted.

The slot comprises several vertical, or substantially vertical, free slot holes at a vertical center part of the slot and several substantially vertical blast holes surrounding the free slot holes. The free slot holes are not charged with explosives. The free slot holes extend to the lower drift and may have greater diameters than the surrounding blast holes. Purpose of the free slot holes is to provide some central space inside the slot and to assist thereby the blasting and fragmentation of the rock material. In other words, the free slot holes create initial free volume for expanding rock mass during the blast.

According to an embodiment, the apparatus provides on a display device at least two selectable views of the first stope ring in different view angles. The apparatus is also configured to define and present the blast sections of the first stope ring in response to instructions input to the apparatus.

In other words, the apparatus provides a visual tool for a designer to define the blast sections on the display device. This way the design work of the blast sections of the first stope ring is intuitive. Further, the apparatus can provide immediate response and notice for the designer if the volume of the planned blast section does not fit into the available free space. Then possible amendments are easy and quick to execute.

According to an embodiment, the apparatus is configured to generate automatically a proposal of the blast sections of the first stope ring. Then the apparatus considers automatically also the volumes of the blasted rock material in relation to the available free space.

In order to implement the automatic feature, the apparatus may be provided with an excavation plan comprising data on shape of the stope and data on an initial free space below the stope. Further, the apparatus may be provided with realized drilling data on drill holes drilled for the stope.

According to an embodiment, the apparatus is configured to present at least in one of the views the drill holes in relation to the following limiting elements: outlines of a horizontal lower drift serving as the initial free space; outlines of a horizontal upper drift serving as a passage for the charging and comprising openings of the drill holes; and boundary lines of an ore body at the first stope ring.

According to an embodiment, the apparatus is configured to provide on a display device a top view and a side view of drill holes of the first stope ring. The top view comprises presentation of start points and projections of angles of the drill holes. The side view comprises presentation of the drill holes in a fan pattern and in relation to the outlines of the horizontal drifts and the boundaries of the ore body.

According to an embodiment, the apparatus is provided with realized data on drill holes drilled for the first stope ring. The realized data comprises properties of the drilled rock material surrounding the drill holes of the first stope whereby the apparatus is configured to take the rock data into account when estimating the amount of the expansion of the rock material of each blast section of the first stope ring.

The gathered data on properties of the drilled rock material can also be used for providing suggestion on amount of a charge used for each drill hole of each blast section.

According to an embodiment, the apparatus is configured to provide a designer advice for setting boarders of the selected blast section so that that the volume of the selected blast section in the blasted state matches with the available free space on the basis of the executed comparison.

According to an embodiment, the apparatus is configured to generate suggestions on the divide of the blast sections. Then the apparatus calculates suitable sizes for each blast section and provides a proposal of boarders limiting the blast sections. In this embodiment, higher level of automation is implemented. However, the designer makes the final decisions on the created charging plan.

According to an embodiment, the apparatus is configured to provide a warning, a notice, or a visual indication on the display device for the designer if volume of the selected blast section is too big and needs to be limited. This is a relatively simple way to assist the designer to create proper charging plans.

According to an embodiment, the apparatus is configured to determine charging depth for drill holes of the first stope ring based on realized drill data of the drill holes and set boarders of the blast sections.

In other words, the apparatus can assist the designer by providing data on charging depths i.e., insertion depths of the charges, for blast holes at each blast section. The designer can then decide amount of blast material and implemented detonators. The charging work is facilitated, and the blasting can be more accurate when the charges are correctly positioned.

According to an embodiment, the apparatus may generate a charging plan for the first stope ring. The charging plan can be submitted to a charging device or a special charging rig for executing mechanized charging. The charging plan may comprise data on the charging depth, amount and type of blast material, used detonators, and blasting order.

According to an embodiment, the charging plan generated by the apparatus may comprises at least two separate charges at different charging depths for at least some of the drill holes which are crossing at least two different blast sections. In other words, the downwards directed drill fan comprises drill holes which are directed so that they cross two or more blast sections and then the drill holes participate to the partial blast of two or more blast sections. The apparatus defines insertion depths i.e., positions inside the drill holes, for the two or more charges of the drill holes. The defined insertion depths can be submitted to the charging rig for providing automated charging.

According to an embodiment, the charging rig is configured to adjust amount of inserted blasting material in function of length of the drill hole. Thus, the charging rig comprises an adjustable blasting material feature.

According to an embodiment the disclosed solution relates also to a method for assisting designing charging and blasting of drill holes of several vertical stope rings in a stope excavation in an underground mine The method comprises using at least one data processing device in the designing process; receiving data on realized drill holes drilled for a stope; receiving data on an initial free space located at least partly below the stope; assisting in dividing an initial first stope ring into several blast sections which are configured to be blasted in several partial blasts towards an available free space including at least the initial free space; estimating volume of rock material of selected blast sections in solid non-blasted state and in blasted expanded state; estimating volume of the available free space at the first stope ring; comparing the volume of the selected blast section in the blasted expanded state to the volume of the available free space; and indicating, based on the comparison, when the selected blast section fits in the blasted expanded state into the available free space.

The above disclosed embodiments can be combined in order to form suitable solutions provided with necessary features.

### Brief description of the figures

Some embodiments are described in more detail in the accompanying drawings, in which
Figure 1 is a schematic side view showing a rock drilling rig executing long hole drilling in a drift,
Figure 2 is a schematic view showing a drill hole fan drilled from an upper drift towards a lower drift,
Figure 3 is a schematic view showing a drill hole fan drilled from a lower drift towards an upper drift,
Figure 4a is a schematic view showing a drilled fan of several drill holes and Figure 4b shows progress of a stope excavation process in several successive stope rings,
Figures 5a - 5c are a schematic side views showing blasting of an initial first stope ring and progress of blasting process thereafter,
Figure 6 is a schematic view showing charging from an upper drift and emptying of a heap of blasted rock material via a lower drift,
Figures 7a - 7c are schematic views showing blasting of a slot for an initial first stope ring,
Figure 8 is a schematic diagram showing some features relating to an apparatus for assisting a designer to design charging and blasting,
Figure 9 is a schematic diagram demonstrating swelling of rock material when being blasted and comparison to a free volume intended to receive the blasted rock material,
Figures 10a and 10b are schematic views of two display views presented for a designer regarding a first stope ring comprising a slot with a first blast section,
Figure 11 is a schematic view showing division of a first stope ring into several blast sections,
Figures 12a and 12b are schematic views demonstrating how an emphasized blast section of a first stope ring is visible in side view and top view on a display device, and
Figures 13a and 13b are schematic views demonstrating display views of a blast section of a second stope ring following a first stope ring.

For the sake of clarity, the figures show some embodiments of the disclosed solution in a simplified manner. In the figures, like reference numerals identify like elements.

### Detailed description of some embodiments

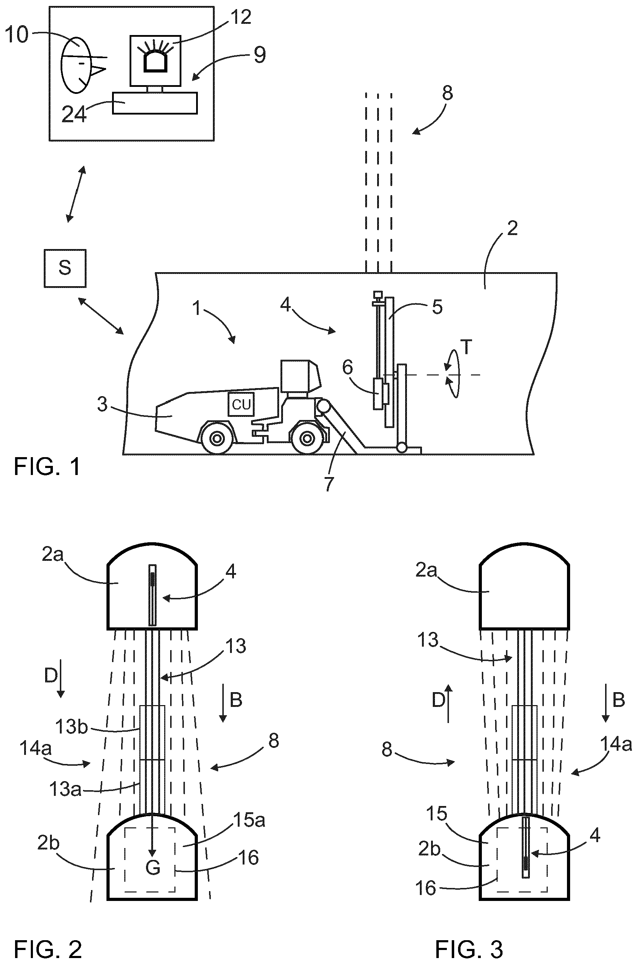

Figure 1 discloses a rock drilling rig 1 for executing long hole drilling for providing blast holes for stope excavation purposes in underground mining. The rock drilling rig 1 is operating in a pre-made drift 2 and comprises a movable carrier 3 and rock drilling unit 4 mounted to the carrier 3. The rock drilling unit 4 comprises a feed beam 5 and rock drilling machine 6 mounted movably on the feed beam 5. The rock drilling unit 4 is supported to drilling boom 7 and can be turned T in relation to transverse turning axis so that drill hole fans 8 can be drilled. In Figure 1 only three parallel drill hole fans 8 are disclosed for clarity reasons. Each drill hole fan comprises several drill holes having different orientations and forming an umbrella type drill hole pattern. The rock drilling rig 1 comprises a control unit CU for controlling the drilling. The control unit CU can communicate with one or more servers S or external electrical devices. The control unit CU may supply data on the realized drill holes including for example data on position, orientation and length of the realized drill holes. Furthermore data on rock quality and hardness can be gathered since the rock drilling machine 6 can produce sensing data during the drilling by means of sensors sensing for example impact energy, feed forces etc. The data on realized drill holes and properties of the drilled rock can be submitted to an apparatus 9 configured to provide aid for a designer 10 designing charging and blasting of vertical stope rings in a stope excavation mining process. The apparatus 9 comprises a data processing device 24 for processing the received data and there are one or more display devices 12 for presenting visual data for the designer 10 of the realized drill holes and properties of the mine, such as ore bodies and data on the drifts 2.

Figure 2 discloses in a simplified manner a drilling unit 4 drilling a drill hole fan 8 from an upper drift 2a towards a vertically located lower drift 2b. Drilling direction D is then vertically downwards. In Figure 3 the drilling is executed from the lower drift 2b towards the upper drift 2a whereby the drilling direction D is vertically upwards. The drill hole fans 8 comprise a slot 13 for creating initial volume for rock material expanding in blast. The slot 13 may comprise drill holes with greater diameter and is indicated in Figures 2 and 3 with greater line thickness. Figures 2 and 3 further disclose that the slot 13 can be divided into several partial slots 13a and 13b. A first partial slot 13a is blasted prior a second partial slot 13b located vertically above it. Blasting of a first stope ring 14a is initiated by blasting the first partial slot 13a towards the lower drift 2b. The lower drift 2b serves as an initial free space 15a which is capable receiving volume of expanded rock material 16 of the first partial slot 13a when being blasted. The expanded rock material 16 is shown in a simplified manner by means of broken lines in Figures 2 and **3****.** The blast is done vertically downwards in a blasting direction B and gravity G assist movement of the blasted rock material towards the initial free space 15. After the blasted and expanded rock material 16 is emptied from the lower drift 2b, the second partial slot 13b can be blasted. The blasting and emptying process continues in partial blast sections. Volumes of the partial blast sections are calculated or estimated in solid non-blasted state and in blasted expanded state. The volume of the expanded rock material is compared to the volume of the free space 15 capable receiving the expanded rock material. The apparatus disclosed in this document is implemented for making the calculations, estimations and comparison measures.

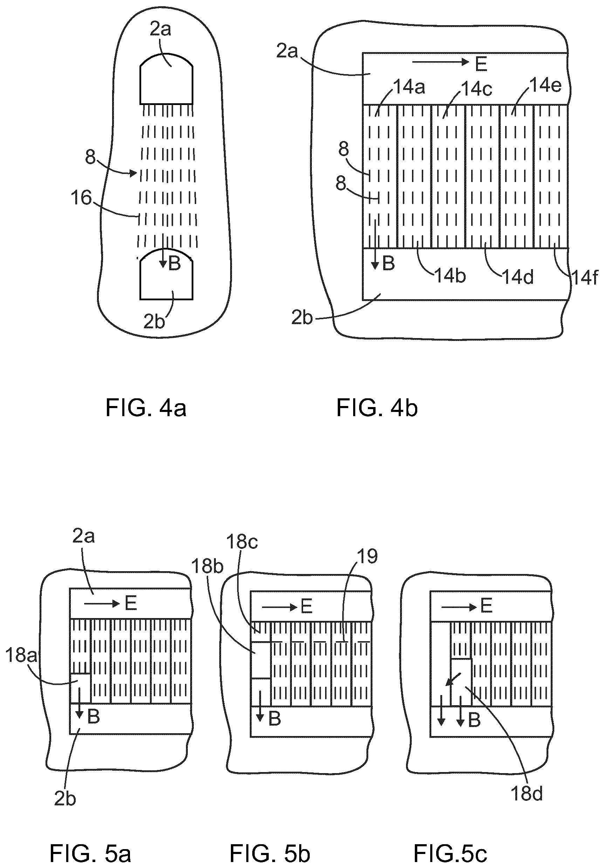

Figures 4a discloses two horizontal drifts 2a and 2b arranged vertically one above another and drill fans 8 with several drill holes 17 drilled between them. Figure 4b discloses in a simplified side view progress of a stope excavation process in several successive stope rings 14a - 14f. The excavation process proceeds gradually forwards in an excavation direction E from a first stope ring 14a.

Figures 5a - 5c discloses in a simplified manner a principle of dividing the stope rings 14a - 14f shown in previous Figure 4b into several partial blast sections which can be blasted in accordance with a designed blasting sequence defining blasting order of the partial blast sections. In Figure 5a a first partial blast section 18a is blasted in blast direction B to the lower drift 2b. In Figure 5b a second partial blast section 18b with a greater volume can be blasted in blast direction B to the lower drift 2b after being emptied from rock material of the first partial blast section 18a. In Figure 5c a third blast section 18c of the first stope ring 14a can be blasted in blast directions B with a fourth partial blast section 18d of a second stope ring 14b. Volumes of the partial blast sections 18 can increase one by one when proceeding further in the excavation direction E since volume of free space enlarges simultaneously. The apparatus disclosed in this document can be used to assistance in dividing the stope rings into suitable partial blast sections and to determine which partial blast sections are to be blasted at each blast stage.

It is also possible to leave uppermost partial blast sections, such as the shown third partial blast section 18c, of each stope ring 14 to be blasted only at a final stage whereby a kind of deck 19 (shown in broken lines in Figure 5b) allows operation in the upper drift 2a until then the deck 19 is blasted in one go.

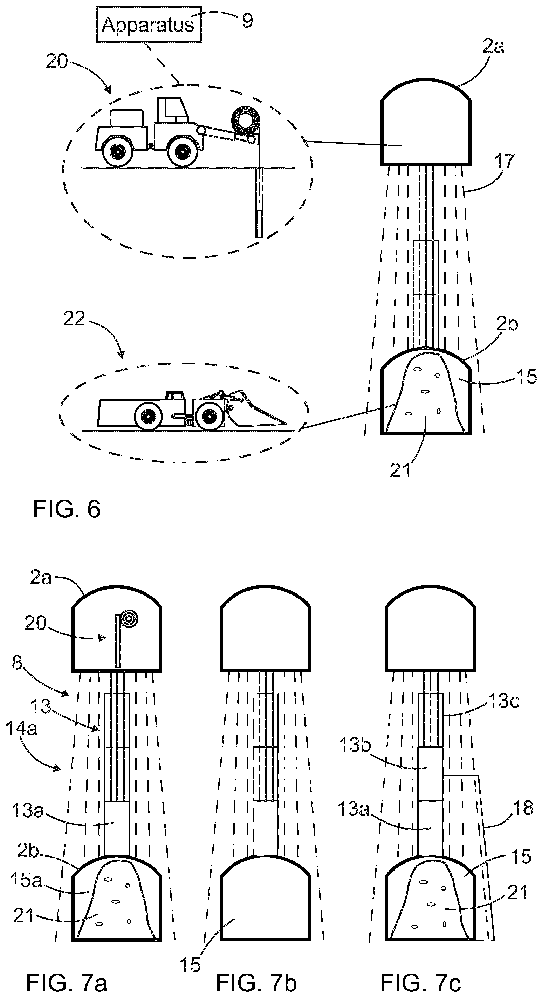

Figure 6 discloses that charging of drill holes 17 of a drill hole fan 8 with explosive material can be done from an upper drift 2a by means of a charging device 20, such as a charging vehicle. The charging device 20 can execute the charging automatically under control of a control unit which is provided with data on charging. The data on charging can be designed in an apparatus 9 and can be communicated to the charging device 20. The charging data may comprise data on amount of explosive material, mounting depths of explosive material in each drill hole 17, and delay times of detonators, for example. The charging device 20 can feed the explosive material and detonators accurately to the designed depth positions inside each drill hole 17.

After each blast a heap 21 of blasted rock material is produced. Emptying of created free space 15 can be done by means of a mining loader 22 operating at a lower drift 2b.

Figures 7a - 7c disclose blasting of a slot 13 for an initial first stope ring 14a. The slot 13 may comprise drill holes which belong to several parallel drill hole fans 8 since thereby enough space can be formed for blasts following the blasts of the slot 13. In Figure 7a the first stope ring 14a is charged by means of a charging device 20 and thereafter a first partial slot 13a is blasted so that a heap 21 is formed to a lower drift 2b. In Figure 7b the heap 21 is hauled away and a greater free space including volume of the lower drift 2b and solid volume of rock material of the first partial slot 13a is created. In Figure 7c charges in a second partial slot 13b are fired and a new heap 21 is formed. After the heap 21 is again hauled away, it is possible to blast a third partial slot 13c together with one or more additional partial blast sections 18 since there is enough free space for blasted and expanded rock material. Magnitudes of the partially blasted volumes can be estimated by the apparatus disclosed in this document.

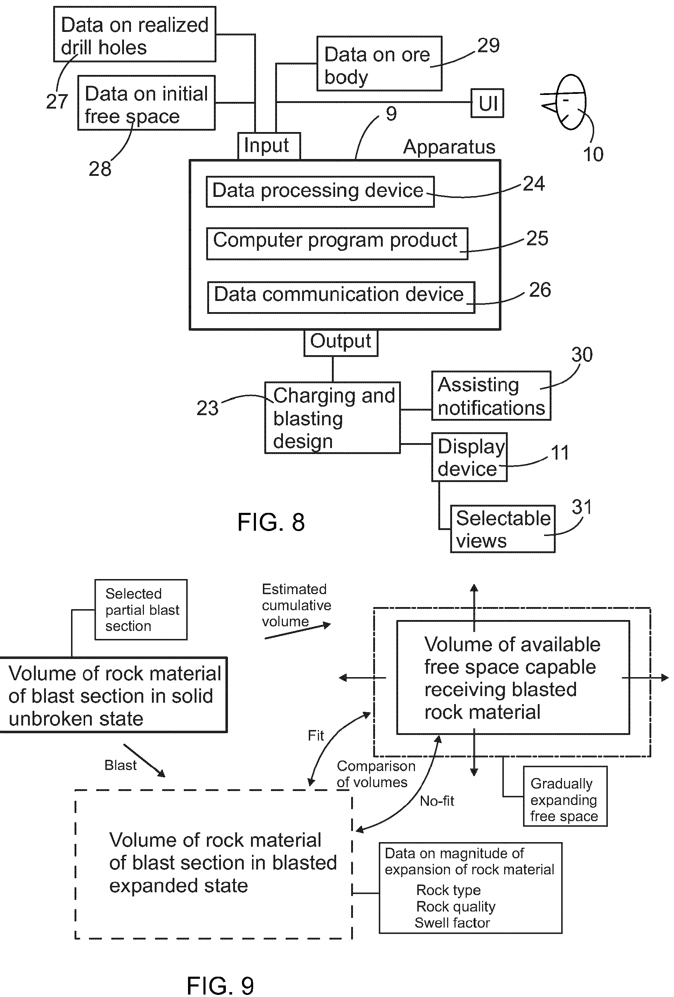

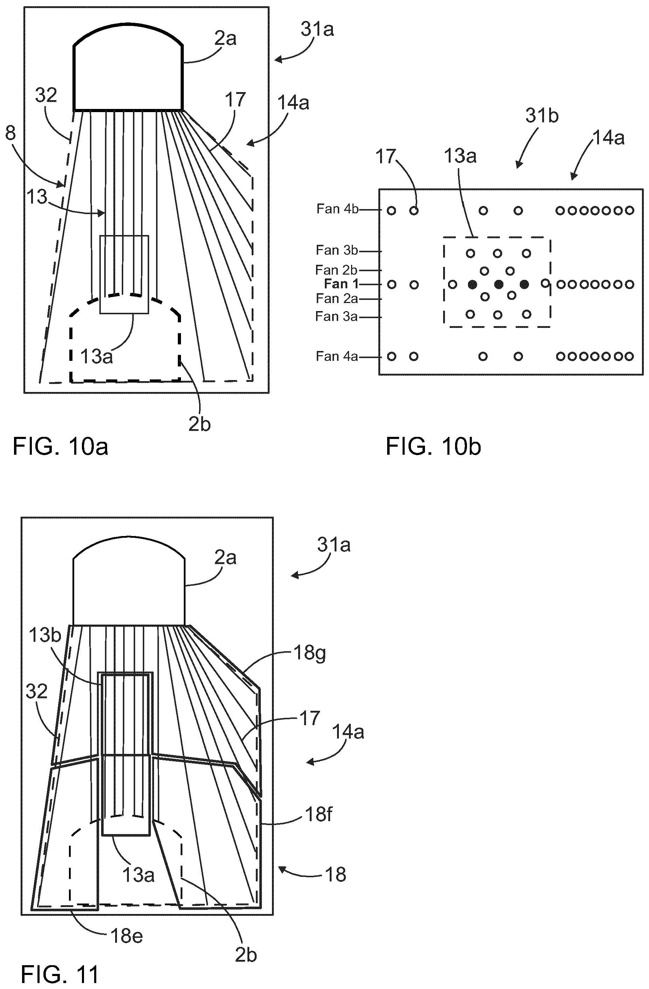

Figure 8 discloses that a designer 10 can utilize an apparatus 9 when designing charging and blasting design 23 at an office. The design work may be executed in a computer aided manner. In other words, the designer 10 can provide parameters, selections and control commands through a user interface UI and thereby co-operate with the apparatus 9 comprising a data processing device 24. At least one computer program product 25 is input or retrieved to the apparatus 9 and can be executed in the data processing device 25. The computer program product 25 may be recorded on a non-transitory computer-readable media including program instructions for implementing various operations executed by the data processing device 24. Required data may be input to the data processing device 24 as individual data elements or may be retrieved from one or more memory devices. The data processing device 25 comprises one or more processors or corresponding devices. Thereby, the data processing device has sufficient processing power and is capable to execute needed calculations and estimations on rock volumes and can also make needed comparisons as instructed by the computer program product and input parameters. The apparatus 9 also comprises a data communication device 26 for communication between the apparatus and one or more servers, control units, memory units, and other electrical devices. Then the apparatus 9 may receive data on realized drill holes 27, data on initial free space 28, data on ore body 29, and possible other data relating to the design work of a charging plan. The apparatus 9 can assist the designer 10 by providing assisting notifications 30, such as suggestions on amount of explosive material as well as mounting depths of the explosive material inside the realized drill holes. The apparatus 9 may execute automatically, or under control of the designer 10, checking measures whether size of blast sections planned by the designer 10 fit into currently available free volume when being blasted, and if not, the apparatus 9 can provide a warning or notice to the designer 10 of the situation. The apparatus 9 may also provide suggestions on how to change the charging plan and to avoid unwanted situations during the blasting phase. For the practical planning work, it is very beneficial that the apparatus 9 can present selectable views 31 on a one or more display devices of the charging plan together with realized drill hole fans and border lines of ore bodies. Examples of such display views 31 are disclosed in Figures 10a - 13b. The apparatus 9 may transmit the results of the designing work not only to the display device 11, but also to memory devices and via the data communication device 26 to a charging device, or anywhere else where the charging and blasting data is needed. This way, the designed charging and blasting design 23 may be displayed, stored and transmitted to desired location.

Figure 9 is a simplified diagram demonstrating swelling of rock material when being blasted and comparison to a free volume intended to receive the blasted rock material. An apparatus can calculate or estimate volume of rock material in a solid state in response to design of a partial blast section defined by a designer. The designer can define size of the partial blast section visually on a display device, for example. The designer can move boarder lines on the display device and the apparatus is capable to estimate updated volumes. The apparatus can also calculate or estimate volume of expanded blasted rock material in response to the estimated volume in solid state and data on magnitude of expansion of each rock type being excavated. Volume of available free space is also calculated or estimated since the free space expands gradually when blasting process of the partial blast sections proceeds.

Figure 10a discloses a side view 31a of a charging plan seen in a longitudinal direction of drifts 2a and 2b. The side view comprises presentation of realized drill holes 17 in a fan pattern 8 and in relation to the outlines of the horizontal drifts 2a, 2b and boundaries 32 of the ore body. The boundaries 32 are shown in broken lines. As can be seen the realized drill holes 17 are orientated in the drill hole fan 8 in accordance with the boundaries 32 as well as their lengths. In Figure 10a a first stope ring 14a comprising a slot 13 with a first partial slot 13a is shown. The first partial slot 13a is an initial first partial blast section to be blasted.

Figure 10b disclosed a top view 31b which can be presented simultaneous on a display device for a designer. The top view 31b comprises presentation of start points of the realized drill holes 17 belonging to several parallel drill hole fans Fan 1 - Fan 4b of the first stope ring 14a. As can be seen, the first partial slot 13a comprises several drill holes 17 being part of several neighboring fans Fan 1 - Fan 3b. Drill holes with black filling indicate that they are not blast holes but are drill holes with greater diameter and are configured to provide space for the first blast section.

A designer can in co-operation with an apparatus determine for example vertical dimensions of the first partial slot 13a. The apparatus informs the designer if too big volume is included and can make a proposal for the designer. When approved by the designer, the apparatus can determine amount of explosive material needed for blasting the first partial slot 13a. The apparatus can also determine insertion depth of the explosive material for each blast hole of the first partial slot. Further, the apparatus can determine delay times for the explosive material inserted into the blast holes for controlling firing of the explosives.

Figure 11 discloses a side view 31a of a first stope ring 14a which is divided into several blast sections 18, 13a, 13b, 18e, 18f and 18g. There is a first partial slot 13a and a second partial slot 13b above it. The partial slots 13a, 13b are blast sections 18 which are detonated before other blast sections 18e, 18f and 18g. A designer can set borders of the blast sections 18e, 18f and 18g in co-operation with an apparatus assisting the design work. Border lines can be moved on the display device and the apparatus updates estimated volumes of the blast sections 18. Thereby the designed work is intuitive.

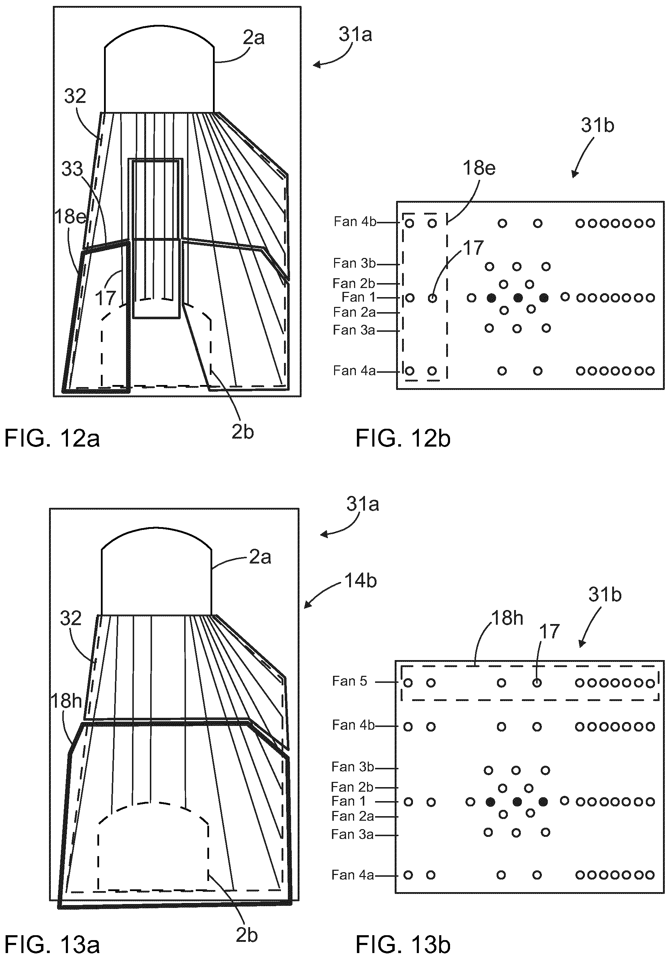

Figure 12b discloses as an example how the blast section 18e shown in Figure 11 and emphasized in Figure 12a can be shown in top-view 31b presentation. If for example an upper boarder line 33 of the blast section 18e is moved vertically upwards or downwards, or if its orientation is amended, an apparatus assisting a designer can update volume estimations and can also update charging amount and height locations of explosive inside the drill holes 17.

Figures 13a and 13b disclose display views 31a, 31b of a blast section 18h of a second stope ring 14b following a first stope ring 14a shown in previous Figures 10a - 12b. The designer can also in this case make amendments to borders limiting the blast section 18h and the apparatus provides the designer with assisting data for making the amendments and decisions. When the design is approved by the designer, the apparatus can calculate the amount of explosive material, insertion depths, firing orders and delays, for example.

The drawings and the related description are only intended to illustrate the idea of the invention. In its details, the invention may vary within the scope of the claims.

## Claims

1. An apparatus (9) comprising at least one data processing device (24) for assisting designing charging and blasting of downwards or upwards directed drill holes (17) of several vertical stope rings (14) in a stope excavation in an underground mine;
and wherein each stope ring (14) comprises at least two drill hole fans (8) provided with several drill holes (17);
the apparatus (9) is provided with data on realized drill holes (27) drilled for a stope and data on an initial free space (28) located at least partly below the stope;
**characterized in that** the apparatus (9) is configured to assist in dividing an initial first stope ring (14a) into several blast sections (13a, 13b, 18) which are configured to be blasted in several partial blasts towards an available free space (15) including at least the initial free space (15a) ;
the apparatus (9) is configured to estimate volume of rock material of selected blast sections (13a, 13b, 18) in solid non-blasted state and in blasted expanded state;
the apparatus (9) is configured to estimate volume of the available free space (15) at the first stope ring (14a);
and the apparatus (9) is configured to compare the volume of the selected blast section (13a, 13b, 18) in the blasted expanded state to the volume of the available free space (15) and is configured to indicate based on the comparison when the selected blast section (13a, 13b, 18) fits in the blasted expanded state into the available free space (15).

2. The apparatus as claimed in claim 1, **characterized in that**
the apparatus (9) is further configured to assist designing a slot (13) for the first stope ring (14a) and to assist in dividing the slot (13) into at least two partial slots (13a, 13b) one on top of the other wherein a first partial slot (13a) is closest to the initial free space (15a) and is provided with a prior blasting order than a second partial slot (13b) vertically above the first partial slot (13a);
and the apparatus (9) is configured to estimate volume of rock material in the blasted expanded state of the first partial slot (13a) and is configured to compare the estimated volume to the volume of the initial free space (15a).

3. The apparatus as claimed in claim 1 or 2, **characterized in that**
the apparatus (9) is configured to provide on a display device (12) at least two selectable views (31, 31a, 31b) of the first stope ring (14a) in different view angles;
and the apparatus (9) is configured to define and present the blast sections (13a, 13b, 18) of the first stope ring (14a) in response to instructions input to the apparatus (9).

4. The apparatus as claimed in claim 3, **characterized in that**
the apparatus (9) is configured to present at least in one of the views (31, 31a, 31b) the drill holes (17) in relation to the following limiting elements: outlines of a horizontal lower drift (2b) serving as the initial free space (15a); outlines of a horizontal upper drift (2a) serving as a passage for the charging and comprising openings of the drill holes (17); and boundary lines (32) of an ore body at the first stope ring (14a).

5. The apparatus as claimed in claim 3 or 4, **characterized in that**
the apparatus (9) is configured to provide on a display device (12) a top view (31b) and a side view (31a) of drill holes (17) of the first stope ring (14a);
wherein the top view (31b) comprises presentation of start points and projections of angles of the drill holes (17);
and wherein the side view (31a) comprises presentation of the drill holes (17) in a fan pattern (8) and in relation to the outlines of the horizontal drifts (2a, 2b) and the boundaries (32) of the ore body.

6. The apparatus as claimed in any one of the preceding claims 1 to 5, **characterized in that**
the apparatus (9) is provided with realized data on drill holes (27) drilled for the first stope ring (14a); and
the realized data (27) comprises properties of the drilled rock material surrounding the drill holes (17) of the first stope ring (14a) whereby the apparatus (9) is configured to take the rock data into account when estimating the amount of the expansion of the rock material of each blast section of the first stope ring (14a).

7. The apparatus as claimed in any one of the preceding claims 1 to 6, **characterized in that**
the apparatus (9) is configured to provide a designer (10) advice for setting boarders of the selected blast section (13a, 13b, 18) so that that the volume of the selected blast section in the blasted state matches with the available free space (15) on the basis of the executed comparison.

8. The apparatus as claimed in any one of the preceding claims 1 to 7, **characterized in that**
the apparatus (9) is configured to determine charging depth for drill holes (17) of the first stope ring (14a) based on realized drill data (27) of the drill holes and set boarders of the blast sections.

9. A method for assisting designing charging and blasting of drill holes (17) of several vertical stope rings (14) in a stope excavation in an underground mine;
and wherein each stope ring comprises at least two drill hole fans (8) provided with several drill holes (17);
using at least one data processing device (24) in the designing process;
receiving data on realized drill holes (27) drilled for a stope;
**characterized by** receiving data on an initial free space (28) located at least partly below the stope;
assisting in dividing an initial first stope ring (14a) into several blast sections (13a, 13b, 18) which are configured to be blasted in several partial blasts towards an available free space (15) including at least the initial free space (15a);
estimating volume of rock material of selected blast sections (13a, 13b, 18) in solid non-blasted state and in blasted expanded state;
estimating volume of the available free space (15) at the first stope ring (14a);
comparing the volume of the selected blast section (13a, 13b, 18) in the blasted expanded state to the volume of the available free space (15);
and indicating, based on the comparison, when the selected blast section (13a, 13b, 18) fits in the blasted expanded state into the available free space (15).

## Patentansprüche

1. Einrichtung (9), die mindestens eine Datenverarbeitungsvorrichtung (24) zum Unterstützen beim Entwerfen von Laden und Sprengen von nach unten oder nach oben gerichteten Bohrlöchern (17) mehrerer vertikaler Abbauringe (14) in einem Abbaukammerausbruch in einem Untertagebergwerk umfasst;
und wobei jeder Abbauring (14) mindestens zwei Bohrlochfächer (8) umfasst, die jeweils mit mehreren Bohrlöchern (17) bereitgestellt sind;
wobei die Einrichtung (9) mit Daten über erstellte Bohrlöcher (27) bereitgestellt wird, die für einen Abbau gebohrt wurden, und mit Daten über einen anfänglichen freien Raum (28), der mindestens teilweise unter dem Abbau gelegen ist;
**dadurch gekennzeichnet, dass**
die Einrichtung (9) so konfiguriert ist, dass sie dabei unterstützt, einen anfänglichen ersten Abbauring (14a) in mehrere Sprengabschnitte (13a, 13b, 18) zu unterteilen, die so konfiguriert sind, dass sie in mehreren Teilsprengungen in Richtung eines verfügbaren freien Raums (15) gesprengt werden, der mindestens den anfänglichen freien Raum (15a) einschließt;
die Einrichtung (9) so konfiguriert ist, dass sie Volumen von Gesteinsmaterial ausgewählter Sprengabschnitte (13a, 13b, 18) im festen, ungesprengten Zustand und im gesprengten, expandierten Zustand schätzt;
die Einrichtung (9) so konfiguriert ist, dass sie Volumen des verfügbaren freien Raums (15) am ersten Abbauring (14a) schätzt;
die Einrichtung (9) so konfiguriert ist, dass sie das Volumen des ausgewählten Sprengabschnitts (13a, 13b, 18) im gesprengten, expandierten Zustand mit dem Volumen des verfügbaren freien Raums (15) vergleicht und basierend auf dem Vergleich angibt, wann der ausgewählte Sprengabschnitt (13a, 13b, 18) im gesprengten, expandierten Zustand in den verfügbaren freien Raum (15) passt.

2. Einrichtung nach Anspruch 1, **dadurch gekennzeichnet, dass**
die Einrichtung (9) weiter so konfiguriert ist, dass sie beim Entwerfen eines Schlitzes (13) für den ersten Abbauring (14a) unterstützt und dabei unterstützt, den Schlitz (13) in mindestens zwei übereinander liegende Teilschlitze (13a, 13b) zu unterteilen, wobei ein erster Teilschlitz (13a) dem anfänglichen freien Raum (15a) am nächsten liegt und mit einer höheren Sprengreihenfolge bereitgestellt ist als ein zweiter Teilschlitz (13b) vertikal über dem ersten Teilschlitz (13a);
die Einrichtung (9) so konfiguriert ist, dass sie Volumen von Gesteinsmaterial im gesprengten, expandierten Zustand des ersten Teilschlitzes (13a) schätzt und so konfiguriert ist, dass sie das geschätzte Volumen mit dem Volumen des anfänglichen freien Raumes (15a) vergleicht.

3. Einrichtung nach Anspruch 1 oder 2, **dadurch gekennzeichnet, dass**
die Einrichtung (9) so konfiguriert ist, dass sie auf einer Anzeigevorrichtung (12) mindestens zwei auswählbare Ansichten (31, 31a, 31b) des ersten Abbaurings (14a) aus verschiedenen Blickwinkeln bereitstellt;
und die Einrichtung (9) so konfiguriert ist, dass sie die Sprengabschnitte (13a, 13b, 18) des ersten Abbaurings (14a) als Reaktion auf in die Einrichtung (9) eingegebene Anweisungen definiert und darstellt.

4. Einrichtung nach Anspruch 3, **dadurch gekennzeichnet, dass**
die Einrichtung (9) so konfiguriert ist, dass sie in mindestens einer der Ansichten (31, 31a, 31b) die Bohrlöcher (17) in Bezug auf die folgenden Begrenzungselemente darstellt: Umrisse eines horizontalen unteren Stollens (2b), der als der anfängliche freie Raum (15a) dient; Umrisse eines horizontalen oberen Stollens (2a), der als Durchgang zum Laden dient und Öffnungen der Bohrlöcher (17) umfasst; und Begrenzungslinien (32) eines Erzkörpers am ersten Abbauring (14a).

5. Einrichtung nach Anspruch 3 oder 4, **dadurch gekennzeichnet, dass**
die Einrichtung (9) so konfiguriert ist, dass sie auf einer Anzeigevorrichtung (12) eine Draufsicht (31b) und eine Seitenansicht (31a) von Bohrlöchern (17) des ersten Abbaurings (14a) bereitstellt;
wobei die Draufsicht (31b) Darstellung von Startpunkten und Projektionen von Winkeln der Bohrlöcher (17) umfasst;
und wobei die Seitenansicht (31a) Darstellung von Bohrlöchern (17) in einem Fächermuster (8) und in Bezug auf die Umrisse der horizontalen Stollen (2a, 2b) und die Grenzen (32) des Erzkörpers umfasst.

6. Einrichtung nach einem der vorstehenden Ansprüche 1 bis 5, **dadurch gekennzeichnet, dass**
die Einrichtung (9) mit erstellten Daten zu für den ersten Abbauring (14a) gebohrten Löchern (27) bereitgestellt ist; und
die erstellten Daten (27) Eigenschaften des gebohrten Gesteinsmaterials umfassen, das die Bohrlöcher (17) des ersten Abbaurings (14a) umgibt, wobei die Einrichtung (9) so konfiguriert ist, dass sie die Gesteinsdaten bei Schätzen des Ausmaßes der Ausdehnung des Gesteinsmaterials von jedem Sprengabschnitt des ersten Abbaurings (14a) berücksichtigt.

7. Einrichtung nach einem der vorstehenden Ansprüche 1 bis 6, **dadurch gekennzeichnet, dass**
die Einrichtung (9) so konfiguriert ist, dass sie einem Entwerfer (10) Ratschläge zum Festlegen von Grenzen des ausgewählten Sprengabschnitts (13a, 13b, 18) bereitstellt, sodass das Volumen des ausgewählten Sprengabschnitts im gesprengten Zustand auf Basis des ausgeführten Vergleichs mit dem verfügbaren freien Raum (15) übereinstimmt.

8. Einrichtung nach einem der vorstehenden Ansprüche 1 bis 7, **dadurch gekennzeichnet, dass**
die Einrichtung (9) so konfiguriert ist, dass sie Ladetiefe für Bohrlöcher (17) des ersten Abbaurings (14a) basierend auf erstellten Bohrdaten (27) der Bohrlöcher und festgelegten Grenzen der Sprengabschnitte bestimmt.

9. Verfahren zum Unterstützen beim Entwerfen von Ladung und Sprengung von Bohrlöchern (17) mehrerer vertikaler Abbauringe (14) in einem Abbaukammerausbruch in einem Untertagebergwerk;
und wobei jeder Abbauring mindestens zwei Bohrlochfächer (8) umfasst, die mit jeweils mehreren Bohrlöchern (17) bereitgestellt sind;
Verwenden mindestens einer Datenverarbeitungsvorrichtung (24) im Entwurfsprozess;
Empfangen von Daten über erstellte Bohrlöcher (27), die für einen Abbau gebohrt wurden; **gekennzeichnet durch**
Empfangen von Daten über einen anfänglichen freien Raum (28), der mindestens teilweise unter dem Abbau gelegen ist;
Unterstützen beim Aufteilen eines anfänglichen ersten Abbaurings (14a) in mehrere Sprengabschnitte (13a, 13b, 18), die so konfiguriert sind, dass sie in mehreren Teilsprengungen in Richtung eines verfügbaren freien Raums (15) gesprengt werden, der mindestens den anfänglichen freien Raum (15a) einschließt;
Schätzen von Volumen von Gesteinsmaterial ausgewählter Sprengabschnitte (13a, 13b, 18) im festen, ungesprengten Zustand und im gesprengten, expandierten Zustand;
Schätzen von Volumen des verfügbaren freien Raums (15) am ersten Abbauring (14a); Vergleichen des Volumens des ausgewählten Sprengabschnitts (13a, 13b, 18) im gesprengten, expandierten Zustand mit dem Volumen des verfügbaren freien Raums (15);
und, basierend auf dem Vergleich, Angeben, wann der ausgewählte Sprengabschnitt (13a, 13b, 18) im gesprengten, expandierten Zustand in den verfügbaren freien Raum (15) passt.

## Revendications

1. Appareil (9) comprenant au moins un dispositif de traitement de données (24) pour assister la conception du chargement et du dynamitage de trous de forage dirigés vers le bas ou vers le haut (17) de plusieurs anneaux d'abattage verticaux (14) dans une excavation d'abattage dans une mine souterraine ;
et dans lequel chaque anneau d'abattage (14) comprend au moins deux éventails de trou de forage (8) pourvus de plusieurs trous de forage (17) ;
l'appareil (9) est pourvu de données sur des trous de forage réalisés (27) forés pour un abattage et de données sur un espace libre initial (28) situé au moins partiellement sous l'abattage ;
**caractérisé en ce que**
l'appareil (9) est configuré pour assister la division d'un premier anneau d'abattage initial (14a) en plusieurs sections de dynamitage (13a, 13b, 18) qui sont configurées pour être dynamitées en plusieurs dynamitages partiels vers un espace libre disponible (15) incluant au moins l'espace libre initial (15a) ;
l'appareil (9) est configuré pour estimer un volume de matériau rocheux de sections de dynamitage sélectionnées (13a, 13b, 18) à l'état non dynamité solide et à l'état dynamité expansé;
l'appareil (9) est configuré pour estimer un volume de l'espace libre disponible (15) au niveau du premier anneau d'abattage (14a) ;
et l'appareil (9) est configuré pour comparer le volume de la section de dynamitage sélectionnée (13a, 13b, 18) à l'état expansé dynamité au volume de l'espace libre disponible (15) et est configuré pour indiquer, sur la base de la comparaison, quand la section de dynamitage sélectionnée (13a, 13b, 18) tient à l'état dynamité expansé dans l'espace libre disponible (15).

2. Appareil selon la revendication 1, **caractérisé en ce que**
l'appareil (9) est en outre configuré pour assister la conception d'une fente (13) pour le premier anneau d'abattage (14a) et pour assister la division de la fente (13) en au moins deux fentes partielles (13a, 13b) l'une sur l'autre, dans lequel une première fente partielle (13a) est la plus proche de l'espace libre initial (15a) et est pourvue d'un ordre de dynamitage antérieur à une seconde fente partielle (13b) verticalement au-dessus de la première fente partielle (13a) ;
et l'appareil (9) est configuré pour estimer un volume de matériau rocheux dans l'état expansé dynamité de la première fente partielle (13a) et est configuré pour comparer le volume estimé au volume de l'espace libre initial (15a).

3. Appareil selon la revendication 1 ou 2, **caractérisé en ce que**
l'appareil (9) est configuré pour fournir sur un dispositif d'affichage (12) au moins deux vues sélectionnables (31, 31a, 31b) du premier anneau d'abattage (14a) dans différents angles de vue ;
et l'appareil (9) est configuré pour définir et présenter les sections de dynamitage (13a, 13b, 18) du premier anneau d'abattage (14a) en réponse à des instructions entrées dans l'appareil (9).

4. Appareil selon la revendication 3, **caractérisé en ce que**
l'appareil (9) est configuré pour présenter au moins dans une des vues (31, 31a, 31b) les trous de forage (17) par rapport aux éléments limitants suivants : contours d'une galerie inférieure horizontale (2b) servant d'espace libre initial (15a) ; contours d'une galerie supérieure horizontale (2a) servant de passage pour le chargement et comprenant des ouvertures des trous de forage (17) ; et lignes de limite (32) d'un corps minéralisé au niveau du premier anneau d'abattage (14a).

5. Appareil selon la revendication 3 ou 4, **caractérisé en ce que**
l'appareil (9) est configuré pour fournir sur un dispositif d'affichage (12) une vue de dessus (31b) et une vue de côté (31a) des trous de forage (17) du premier anneau d'abattage (14a) ;
dans lequel la vue de dessus (31b) comprend une présentation de points de départ et des projections d'angles des trous de forage (17) ;
et dans lequel la vue de côté (31a) comprend une présentation des trous de forage (17) dans un motif en éventail (8) et par rapport aux contours des galeries horizontales (2a, 2b) et aux limites (32) du corps minéralisé.

6. Appareil selon l'une quelconque des revendications précédentes 1 à 5, **caractérisé en ce que**
l'appareil (9) est pourvu de données réalisées sur des trous de forage (27) forés pour le premier anneau d'abattage (14a) ; et
les données réalisées (27) comprennent des propriétés du matériau rocheux foré entourant les trous de forage (17) du premier anneau d'abattage (14a) moyennant quoi l'appareil (9) est configuré pour prendre en compte les données de roche lors de l'estimation de la quantité d'expansion du matériau rocheux de chaque section de dynamitage du premier anneau d'abattage (14a).

7. Appareil selon l'une quelconque des revendications précédentes 1 à 6, **caractérisé en ce que**
l'appareil (9) est configuré pour fournir au concepteur (10) des conseils pour définir des limites de la section de dynamitage sélectionnée (13a, 13b, 18) de sorte que le volume de la section de dynamitage sélectionnée à l'état dynamité correspond à l'espace libre disponible (15) sur la base de la comparaison exécutée.

8. Appareil selon l'une quelconque des revendications précédentes 1 à 7, **caractérisé en ce que**
l'appareil (9) est configuré pour déterminer la profondeur de chargement de trous de forage (17) du premier anneau d'abattage (14a) sur la base de données de forage réalisées (27) des trous de forage et limites des sections de dynamitage.

9. Procédé d'assistance de conception de chargement et de dynamitage de trous de forage (17) de plusieurs anneaux d'abattage verticaux (14) dans une excavation d'abattage dans une mine souterraine ;
et dans lequel chaque anneau d'abattage comprend au moins deux éventails de trou de forage (8) pourvus de plusieurs trous de forage (17) ;
l'utilisation d'au moins un dispositif de traitement de données (24) dans le processus de conception ;
la réception de données sur des trous de forage réalisés (27) forés pour un abattage ; **caractérisé par**
la réception de données sur un espace libre initial (28) situé au moins partiellement sous l'abattage ;
l'assistance de division d'un premier anneau d'abattage initial (14a) en plusieurs sections de dynamitage (13a, 13b, 18) qui sont configurées pour être dynamitées en plusieurs dynamitages partiels vers un espace libre disponible (15) incluant au moins l'espace libre initial (15a) ;
l'estimation de volume de matériau rocheux de sections de dynamitage sélectionnées (13a, 13b, 18) à l'état non dynamité solide et à l'état dynamité expansé ;
l'estimation d'un volume de l'espace libre disponible (15) au niveau du premier anneau d'abattage (14a) ;
la comparaison du volume de la section de dynamitage sélectionnée (13a, 13b, 18) à l'état expansé dynamité au volume de l'espace libre disponible (15) ;
et l'indication, sur la base de la comparaison, quand la section de dynamitage sélectionnée (13a, 13b, 18) tient à l'état expansé dynamité dans l'espace libre disponible (15).
